# EUROPEAN PATENT APPLICATION

(11) **EP 4 340 554 A1**
(43) Date of publication of application: **20.03.2024**
(21) Application number: 23196896.7
(22) Date of filing: 12.09.2023
(51) Int. Cl.: H05K 3/34, H05K 1/02

(54) **THERMAL MANAGEMENT FOR FLAT NO LEAD PACKAGES**

(30) Priority: 14.09.2022 US 202217944333
(71) Applicant: Hamilton Sundstrand Corporation, Charlotte, NC 28217-4578 (US)
(72) Inventor: TROTMAN, Alexander, South Windsor, CT, 06074 (US); Schwartz, Judy, Longmeadow, MA, 01106 (US)
(74) Representative: Dehns

(57) **Abstract**

A method of forming a circuit board assembly includes receiving a flat no-lead package (100). The package includes: a housing (102) having a first side (220) and second side; a circuit disposed within the housing; and an exposed thermal belly pad (108) that is thermally coupled to the circuit and passes at least partially through the first side such that it can be exposed to an environment outside of the housing. The method also includes attaching the second side of the flat no-lead package to a first side of a printed circuit board, PCB, (202) such that the exposed thermal belly pad is opposite the first side of the PCB.

## Description

### BACKGROUND

Exemplary embodiments pertain to the art of heat management of electronics and, in particular, to managing heat for flat, no lead packages such as QFNs and DFNs.

As new integrated circuits are created, the spacing of components can get closer and closer and, as such, the need to dissipate heat in such circuits can become important. These circuits are typically included in a case. As circuit/component case styles are introduced to the industry, there is often a direct conflict between the performance capability of a component and its ability to be thermally managed. QFN/DFNs (quad/dual flat pack - no leads) are one of these new case styles, and they commonly utilize a thermal belly pad on the component floor as the sole heat path.

### BRIEF DESCRIPTION

In more aggressive thermal environments, it has been discovered that QFNs/DFNS can cause significant issues on CCAs (circuit card assembly), such as thermal saturation of the surrounding board area and localized "hot spots". Disclosed are systems and method that address such hot spots.

In one aspect, a method of forming a circuit board assembly is disclosed. The method includes receiving a flat no-lead package. The package includes: a housing having a first side and second side; a circuit disposed within the housing; and an exposed thermal belly pad that is thermally coupled to the circuit and passes at least partially through the first side such that it can be exposed to an environment outside of the housing. The method also includes attaching the second side of the flat no-lead package to a first side of a printed circuit board (PCB) such that the exposed thermal belly pad is opposite the first side of the PCB.

In embodiments, the method can further include attaching a heat sink to the exposed thermal belly pad.

In embodiments, the heat sink is a finned heat sink.

In embodiments, the heat sink is attached by a thermal paste.

In embodiments, the method can further include attaching a post to the exposed thermal belly pad.

In embodiments, the method can further include: putting the PCB in a housing; and thermally connecting the post the housing.

In embodiments, the post can be attached by a thermal paste.

In embodiments, the PCB can include traces thereon and the method can further include electrically connecting the flat no-lead package to the traces.

Also disclosed is a circuit board assembly that includes: a flat no-lead package, wherein the package includes: a housing having a first side and second side; a circuit disposed within the housing; and an exposed thermal belly pad that is thermally coupled to the circuit and that passes at least partially through the first side; and a printed circuit board (PCB) having traces formed on a first side thereof, wherein the flat no-lead package is attached to a first side of the PCB such that the exposed thermal belly pad is opposite the first side of the PCB.

In embodiments, the assembly can further include a heat sink attached to the exposed thermal belly pad. The heat sink can be a finned heat sink. In one embodiment, the heat sink is a finned heat sink. In one embodiment, the heat sink is attached by a thermal paste.

In embodiments, the assembly can further include a post attached to the exposed thermal belly pad.

In embodiments, the assembly can further include a housing surrounding the PCB and the post can be thermally connected to the housing.

In embodiments, the post can be attached by a thermal paste.

### BRIEF DESCRIPTION OF THE DRAWINGS

The following descriptions should not be considered limiting in any way. With reference to the accompanying drawings, like elements are numbered alike:
FIG. 1 is an example of flat pack no lead package;
FIG. 2 shows an assembly that includes a flat pack no lead package according to one embodiment;
FIG. 3 shows an assembly that includes a flat pack no lead package that includes a post that can be connected to a housing surrounding the assembly; and
FIG. 4 shows an assembly that includes a flat pack no lead package that includes a heat exchanger connected to the flat pack no lead package.

### DETAILED DESCRIPTION

A detailed description of one or more embodiments of the disclosed apparatus and method are presented herein by way of exemplification and not limitation with reference to the Figures.

As noted above, in high density circuits/components such as QFNs and DFNs heat dissipation can become problematic. In particular, the fact that such components have a thermal pad (also known as a belly pad) on a same side of the component (e.g., same side of the component housing) as the metalized terminal pads of the component. In the prior art, the terminal pads and thermal belly pads were typically placed on or near the surface of substrate that is part of a printed circuit board (PCB). In this manner, vendors recommend, and it is industry accepted practice, to utilize the PCB to dissipate heat.

To address the hot spots that such a configuration can lead to as disclosed above are systems (e.g., PCB's with flat no lead packages on them) where the flat no lead package is arranged such that the thermal belly pad and the terminal pads of the package are on the side of the package opposite the PCB. Optionally, a heat sink feature such as fin or a post can be thermally connected to the thermal belly pad to improve heat dissipation.

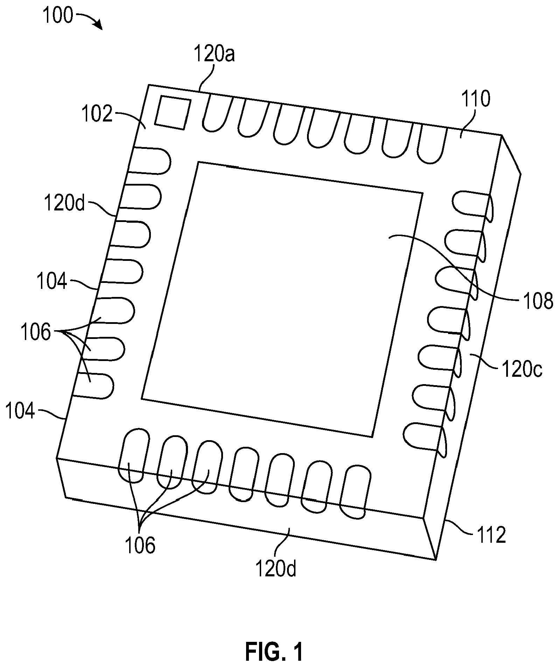

FIG. 1 shows an example of flat, no lead package 100. The package 100 includes a body/housing 102. The body/housing 102 surrounds one or more circuits that are not shown but the skilled artisan will realize that all packages herein include one or more circuits therein.

The housing 102 includes four sides 120a-120d in FIG. 1 and all four sides include one or more openings 104 formed therein. Thus, as configured, the package 100 is a QFN. Of course, only two of sides (e.g., 120a and 120c) may include the openings 104. In such a case, the package may be a DFN. Regardless, herein, the package 100 can include openings in 1, 2, 3 or 4 sides. The openings 104 are holes or slots that expose terminal pads 106 so that electrical communication (e.g., power/data) can be conducted with the circuits inside the package 100. The terminal pads can be connected to a lead frame (not shown) as is known in the art.

As is common in QFNs/DFNs, the package 100 can include a die that is surrounded by the lead frame. The lead frame is made up of a conductive material. The frame can be connected to the die by wire bonds. The terminal pads 106 are electrically connected to the lead frame and allow the die to be electrically connected to a printed circuit board. As shown, the package 100 includes a first or bottom side 110 and a second or top side 112. The package 100 includes an exposed thermal belly pad 108 that passes at least the first side 110 and is exposed to an environment outside of the housing 100. The pad 108 can be an outer surface of the first side 110, level with it or slightly above it. This pad 108 provides an efficient heat path from inside the package to outside the package. In the prior art, the pad was connected thermally to the PCB.

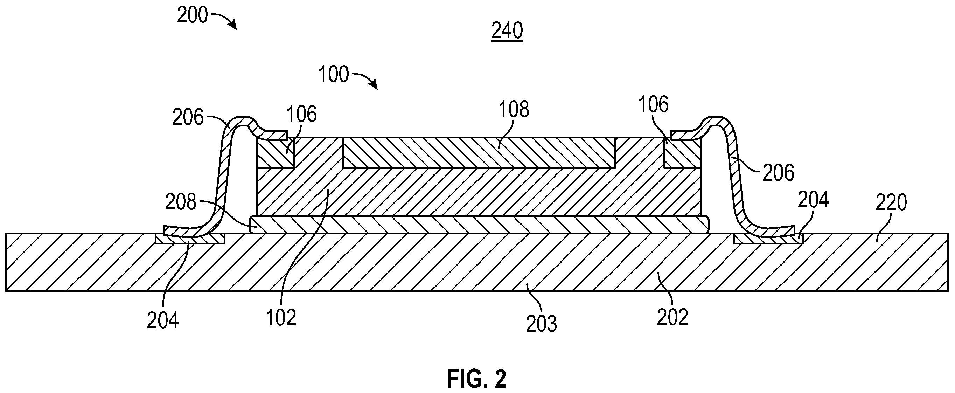

As noted above, in some cases, the heat from the thermal belly pad 108 can create local hot spots on the PCB. FIG. 2 shows one example of how the package 100 can be arranged on a PCB 202 to form an assembly 200. The PCB 202 can include one or more traces 204 formed thereon. The traces 204 can be formed of a conductive such as a metal (e.g., copper) and can be used to route electrical signals and power within and between devices connected to the PCB. The PCB 202 can include a substrate 203 that is formed of a rigid or flexible materials depending on the intended PCB design. Rigid materials can include but are not limited to FR4 or polyimide fiberglass, while flexible circuits and rigid-flex flexible layers typically use high-temperature polyimide films. Common plastic substrates for flexible circuits include polyimide (PI), liquid crystal polymer (LCP), polyester (PET), and polyethylene naphthalate (PEN)

The substrate 203 as is known in the art provides a non-conductive base onto which the traces 204 can be deposited.

In prior art applications, the substrate 203 also served as material to absorb heat from the package 100. In such case, the belly pad 108 was typically thermally connected (e.g., by way of thermal paste) to the PCB or to exposed copper trace(s) on the PCB to which the belly pad can be soldered.

In contrast, herein, the assembly 200 can be formed by placing the second side 112 of the flat no-lead package 100 to a first side 220 of the PCB 202. In this manner, the exposed thermal belly pad 108 is opposite the first side 220 of the PCB 202. This will prevent heat from the thermal belly pad 108 from being directly conducted into the PCB 202. Rather, as illustrated in FIG. 2, heat from the thermal belly pad 108 can be discharged to an environment 240 outside of the housing 102.

The package 100 can be secured to the PCB 202 (and in one embodiment, to the first side 220 of the PCB 202) via an adhesive 208.

One or more metal leads 206 can connect various terminal pads 106 to traces 204 on the board. The metal leads 206 can be wires or preformed and shaped leads, for example.

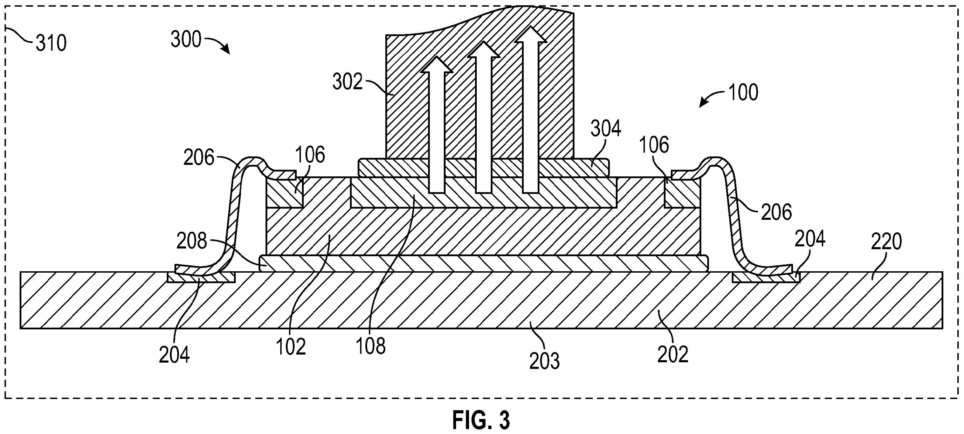

In one embodiment, the "environment" outside of the housing 240 can be air. In another embodiment, the environment can be manifested as a heat transfer post 302 as shown in FIG. 3. The heat transfer post 302 can be connected to the belly pad 108 by a thermal interface material 304 such as a thermal paste. The heat transfer post 302 can be connected to a device housing 310 in which the assembly 100 is disposed. The post 302 can transfer heat in the manner shown by the arrows passing through it.

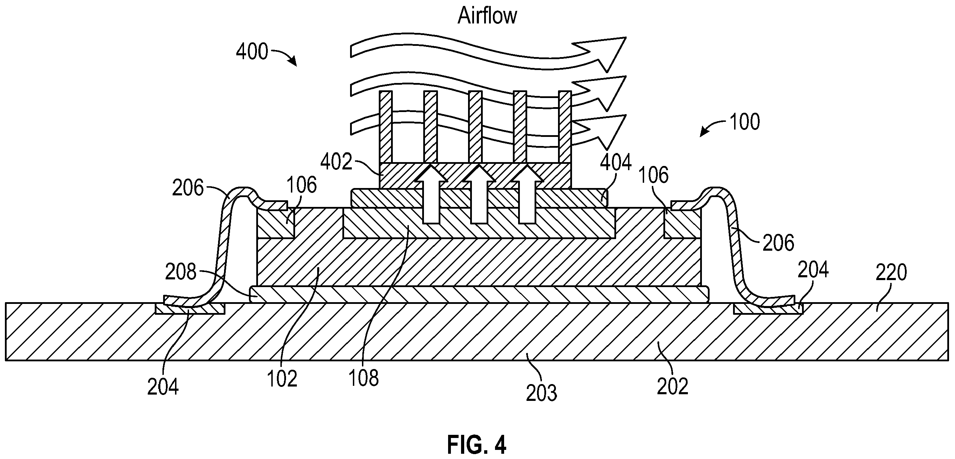

In another embodiment, and as shown in FIG. 4, a heat exchanger 402 (such as a finned heat exchanger) can be connected to the belly pad 108 by a thermal interface material 404 such as a thermal paste. This allows airflow to draw heat away. The other elements of FIGs. 3 and 4 are generally the same as in FIG. 2.

Thus, disclosed are both assemblies and method of forming them that attach a flat no-lead package to a PCB in a manner that is exact opposite of the conventional manner. Such assemblies can reduce or avoid hot spots in the PCB in some embodiments.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made without departing from the scope of the invention as defined by the claims. In addition, many modifications may be made to adapt a particular situation or material to the teachings of the present disclosure without departing from the scope of the claims. Therefore, it is intended that the present disclosure not be limited to the particular embodiment disclosed as the best mode contemplated for carrying out this present disclosure, but that the present disclosure will include all embodiments falling within the scope of the claims.

## Claims

1. A method of forming a circuit board assembly, the method comprising:
receiving a flat no-lead package (100), wherein the package includes: a housing (102) having a first side (220) and second side; a circuit disposed within the housing; and an exposed thermal belly pad (108) that is thermally coupled to the circuit and passes at least partially through the first side such that it can be exposed to an environment outside of the housing; and
attaching the second side of the flat no-lead package to a first side of a printed circuit board, PCB, (202) such that the exposed thermal belly pad is opposite the first side of the PCB.

2. The method of claim 1, further comprising:
attaching a heat sink to the exposed thermal belly pad.

3. The method of claim 2, wherein the heat sink is a finned heat sink.

4. The method of claim 2 or 3, wherein the heat sink is attached by a thermal paste.

5. The method of any preceding claim, further comprising:
attaching a post (302) to the exposed thermal belly pad.

6. The method of claim 5, further comprising:
putting the PCB in a housing; and
thermally connecting the post to the housing.

7. The method of claim 5, wherein the post is attached by a thermal paste.

8. The method of any preceding claim, wherein the PCB includes traces (204) thereon and the method further comprises:
electrically connecting the flat no-lead package to the traces.

9. A circuit board assembly comprising:
a flat no-lead package (100), wherein the package includes: a housing (102) having a first side (220) and second side; a circuit disposed within the housing; and an exposed thermal belly pad that is thermally coupled to the circuit and that passes at least partially through the first side; and
a printed circuit board, PCB, (202) having traces (204) formed on a first side thereof, wherein the flat no-lead package is attached to a first side of the PCB such that the exposed thermal belly pad is opposite the first side of the PCB.

10. The assembly of claim 9, further comprising:
a heat sink attached to the exposed thermal belly pad.

11. The assembly of claim 10, wherein the heat sink is a finned heat sink.

12. The assembly of claim 10 or 11, wherein the heat sink is attached by a thermal paste.

13. The assembly of any of claims 9 to 12, further comprising:
a post (302) attached to the exposed thermal belly pad.

14. The assembly of claim 13, further comprising:
a housing surrounding the PCB; and
wherein the post is thermally connected to the housing.

15. The assembly of claim 13, wherein the post is attached by a thermal paste.
